# EUROPEAN PATENT SPECIFICATION

(11) **EP 2 746 322 B1**
(45) Date of publication and mention of the grant of the patent: **07.03.2018**
(21) Application number: 12198977.6
(22) Date of filing: 21.12.2012
(51) Int. Cl.: C08J 7/04, C09D 175/04, H01L 31/042, H01L 31/048

(54) **A back sheet for photovoltaic modules**
Rückseitige Folie für Photovoltaikmodule
Feuille arrière pour modules photovoltaïques

(43) Date of publication of application: 25.06.2014
(73) Proprietor: AGFA-GEVAERT, 2640 Mortsel (BE)
(72) Inventor: Vangaever, Frank, 2640 Mortsel (BE); Srivastava, Ijya, 2640 Mortsel (BE); Van Aert, Hubertus, 2640 Mortsel (BE)

(56) References cited:
- EP-A1- 2 309 551
- EP-A1- 2 369 637
- EP-A1- 2 426 729
- EP-A1- 2 524 802
- JP-A- 2011 222 575
- US-A1- 2012 298 196

## Description

### FIELD OF THE INVENTION

The invention relates to a solar cell module comprising a solar cell element disposed between a front sheet and a back sheet.

### BACKGROUND OF THE INVENTION

With increasing energy prices and increasing concern over the scarcity and the environmental impact of hydrocarbon fuels, industry is turning to alternative energy sources, such as solar energy.

Photovoltaic (PV) modules, also known as solar modules, are used to produce electrical energy from sunlight. Such modules are based on a variety of semiconductor cell systems (the solar cell) that can absorb light and convert it into electrical energy.

In a typical PV module, the solar cell arrays are positioned between two encapsulant layers, which are further positioned between a front sheet (upper side of the module facing the incoming light) and a back sheet (back side of the module). The most widely used encapsulant is EVA, i.e. Ethylene Vinyl Acetate.

The back sheet provides weather resistance, UV resistance, moisture barrier properties, low dielectric constant and a high breakdown voltage to the solar cell module. To provide such properties to the PV module, a back sheet comprises a weather resistant film, for example a Tedlar™ film, and/or a polyethyleneterephthalate (PET) film. For example a TPT type back sheet, wherein a Tedlar™ film is laminated on both sides of a PET film, or a TPE type back sheet, wherein a Tedlar™ is laminated on one side of a PET film, while on the other side an EVA adhesion layer is provided, are nowadays widely used as back sheet on the market.

Instead of laminating a weather resistant sheet on a support it may be advantageous to coat a weather resistant layer on a support, for example to decrease the cost price of the back sheet. Such a weather resistant layer may be coated from an aqueous or a non-aqueous coating solution. US2009/0151774 for example discloses a back sheet wherein the weather resistant layer is coated on a plastic support instead of laminated.

JP2011/222575 discloses a back sheet including an adhesive layer towards the sealing layer, the adhesive layer comprising a fluorine resin, an inorganic pigment and a polyisocyanate resin.

EP2426729 discloses a back sheet including a cured coating film layer, the coating comprising a hydroxyl-containing fluoropolymer and an isocyanate prepolymer and/or melamine resin.

EP2369637 discloses a back sheet including a resin layer containing a resin obtained by copolymerizing an acrylic polyol resin and a polyisocyanate resin. The polyisocyanate resin is preferably an aliphatic or alicyclic polyisocyanate resin.

Typically, the coated layer has to be cured to obtain the necessary weather resistant properties. The curing efficiency may also determine the coating speed of the weather resistant layer, as the coated layer has to be "dry" enough at the end of the coating process to avoid "sticking" when the back sheet is stored on roll.

### SUMMARY OF THE INVENTION

It is an object of the present invention to provide a solar cell module comprising a solar cell element disposed between a front sheet and a back sheet, wherein the back sheet, while providing sufficient weather resistance, UV resistance and moisture barrier properties to the PV module, is characterized by a lower cost price due to a more efficient curing (i.e. crosslinking) of a weather resistant coating.

### DETAILED DESCRIPTION OF THE INVENTION

The present invention provides a solar cell module (5) comprising a solar cell element (3) encapsulated by an encapsulant (2, 2) and disposed between a front sheet (4) and a back sheet (1), characterized in that the back sheet (1) comprises a polymeric support (10), a weather resistant layer (13) on one side of the support and a primer (11) on the other side of the support facing the encapsulant (2') to enhance the adhesion of the back sheet towards the encapsulant layer (2'), the weather resistant layer comprising a binder containing a crosslinkable group and an aliphatic isocyanate crosslinking agent, characterized in that the weather resistant layer further comprises an aromatic or an alicyclic isocyanate crosslinking agent, wherein the molar ratio of the isocyanate groups of the aliphatic isocyanate crosslinking agents to the isocyanate groups of the aromatic and/or alicyclic crosslinking agents is ≤ 3, and wherein the crosslinkable group of the binder is a hydroxyl group.

### Support

The support, also referred to as substrate, used in the back sheet of the present invention is a polymeric support. Examples of such a polymeric support include supports made of polyesters or polyolefins such as polypropylene and polyethylene or polyamide such as polyamide 12 (Nylon 12). Examples of polyesters that can be used for the support are a polyethylene terephthalate (PET), a polybutylene terephthalate (PBT), a 2,6-naphthalene terephthalate (PEN), a copolymer of 1,4-cyclohexanedimethanol, 1,2-ethanediol and 1,4-benzenedicarboxylic acid (PETG) and a copolyester containing isosorbide. A particularly preferred support is a PET support.

### Production of a polyester support

A typical polyester production process comprises two phases: an esterification and/or transesterification step of a dicarboxylic acid, or its ester derivative, and a diol compound, followed by a polycondensation step.

Optionally, the resulting polyester after the polycondensation step may be subjected to a so called solid state polymerization to further increase the Molecular Weight (MW) of the polyester, for example to decrease the amount of terminal carboxyl groups.

The resulting polyester resin is then fed to a melt extruder to form a biaxially oriented polyester film (i.e. the polyester support) having a specific thickness.

A catalyst is typically used in the polyester production process. Such a catalyst may be present in the esterification step, in the polycondensation step, or in both.

Several other compounds may be added during the polyester production process, to optimize the polymerization reaction and/or the physical properties of the resulting polyester resin or film. Such compounds may be present in the esterification step, in the polycondensation step, in both the esterification and the polycondensation step, or may be added together with the polyester resin to the melt extruder before film formation.

### Dicarboxylic acid

The dicarboxylic acids may be selected from aliphatic, alicyclic and aromatic dicarboxylic acids. Examples of an aliphatic dicarboxylic acid are malonic acid, succinic acid, glutaric acid, adipic acid, suberic acid, sebacic acid, dodecanedioic acid, dimer acid, eicosane dioic acid, pimelic acid, azelaic acid, methylmalonic acid and ethylmalonic acid. Examples of an alicyclic dicarboxylic acid are adamantane dicarboxylic acid, norbornene dicarboxylic acid, cyclohexanedicarboxylic acid and decalin dicarboxylic acid. Examples of an aromatic dicarboxylic acid are terephthalic acid, isophthalic acid, phthalic acid, 1,4-naphthalene dicarboxylic acid, 1,5-naphthalene dicarboxylic acid, 2,6-naphthalene dicarboxylic acid, 1,8-naphthalene dicarboxylic, 4,4'-diphenyl dicarboxylic acid, 4,4'-diphenylether dicarboxylic acid, and 5-sodium-sulfoisophthalic acid.

Preferably, at least one aromatic dicarboxylic acid is used. More preferably, at least 80 wt % of the dicarboxylic acids used is an aromatic dicarboxylic acid. Most preferably, the dicarboxylic acids used are selected from terephthalic acid and isopthalic acid.

### Diol compound

The diol compounds may be selected from aliphatic diol compounds, alicyclic diol compounds and aromatic diol compounds. Examples of aliphatic diol compounds are ethylene glycol, 1,2-propanediol, 1,3-propanediol, 1,4-butanediol, 1,2-butanediol, and 1,3-butanediol.

Examples of alicylic diol compounds are cyclohexane dimethanol, spiroglycol, isosorbide, and 2,2,4,4-tetramethyl-1,3-cyclobutanediol (CBDO).

Examples of aromatic diol compounds are bisphenol A, 1,3-benzenedimethanol, and 1,4-benzenedimethanol.

Preferably, at least one aliphatic diol compound is used. Most preferably, ethylene glycol is used as diol compound.

Compounds having three or more carboxyl groups or hydroxyl groups

When using a small amount of compounds having three or more carboxyl groups or hydroxyl groups, branching of the polyester molecular chains may be induced, therefore promoting the entanglement of the polyester chains. As a result, even though the polyester molecules are hydrolyzed and the molecular weight of the polyester is thereby lowered, embrittlement of the polyester film can be avoided. Such an entanglement may also inhibit thermal shrinkage of the polyester film. Such compounds and the preferred amounts used thereof are disclosed for example in US2011/0306747, paragraph [0121] to [0127].

### Esterification

The aromatic dicarboxylic acid and the aliphatic diol may be introduced into the production process by preparing a slurry containing these compounds, and supplying the slurry to the esterification phase. The esterification may be carried out using a multistage unit of at least two reactors connected in series, in which ethylene glycol is kept under reflux and water and alcohol formed by the reaction are removed out of the system.

The amount of the aliphatic diol, for example ethylene glycol, is preferably between 1.015 and 1.50 mol per mol of the aromatic dicarboxylic acid, for example terephthalic acid, or its ester derivative, more preferably between 1.10 and 1.30 mol, most preferably between 1.15 and 1.25 mol.

### Catalyst

In the polyester production process, any known conventional catalyst may be used, such as alkali metal compounds, alkaline earth metal compounds, zinc compounds, lead compounds, manganese compounds, cobalt compounds, aluminium compounds, antimony compounds, titanium compounds, germanium compounds, or phosphorus compounds. Preferably an antimony compound, a germanium compound or a titanium compound is used in the polyester production.

Most preferably, a titanium catalyst (Ti catalyst) is used. The Ti catalyst includes oxides, hydroxides, alkoxides, carboxylates, carbonates, oxalates, organic chelate Ti complexes, and halides. Two or more different types of Ti compounds may be used. Preferred Ti catalysts are organic chelate Ti complexes with an organic acid as a ligand. The organic acid may be selected from citric acid, lactic acid, trimellitic acid, and malic acid. Preferably a chelate Ti complex with citric acid as ligand is used. Such a citrate chelate Ti catalyst is commercially available as Tyzor AC422 from Dorf Ketal or Ti184 from Catalytic Technologies.

The catalyst may be added in the esterification phase, in the polycondensation phase or in both phases. The amount of the catalyst is preferably from 1 to 50 ppm, more preferably from 2 to 30 ppm, most preferably from 3 to 15 ppm, in terms of the Ti element.

### Phosphorus compound

Preferably, a pentavalent phosphorus compound not having an aromatic ring as a substituent is used in combination with a Ti catalyst.

The pentavalent phosphorus compound may be selected from trimethyl phosphate, triethyl phosphate, tri-n-butyl phosphate, trioctyl phosphate, tris(triethylene glycol) phosphate, methyl acid phosphate, ethyl acid phosphate, monobutyl phosphate, dibutyl phosphate, dioctyl phosphate, and triethylene glycol acid phosphate. Most preferably trimethyl phosphate and triethyl phosphate are used. In combination with the citrate chelate Ti catalyst mentioned above, using trimethyl phosphate or triethyl phosphate results in a polyester resin having a balanced polymerization activity, color tone and thermal stability.

The pentavalent phosphorus compound is preferably added in the esterification phase, but may also be added to the polycondensation phase or to both phases. The amount of pentavalent phosphorus compound is preferably from 1 to 100 ppm, more preferably from 5 to 50 ppm, most preferably from 7.5 to 25 ppm, in terms of the P element.

### Magnesium compound

Adding a magnesium compound (Mg compound) imparts static electricity properties to the resin film. The magnesium compound may be selected from magnesium oxide, magnesium hydroxide, magnesium alkoxide, magnesium acetate, and magnesium carbonate. Among these magnesium compounds, magnesium acetate is preferred.

The Mg compound may be added in the esterification phase, in the polycondensation phase or in both phases. The Mg compound may also be added in the extruder, i.e. in the melt. The amount of the magnesium compound is preferably from 1 to 100 ppm, more preferably from 2 to 50 ppm, most preferably from 3 to 30 ppm, in terms of the Mg element.

### Polycondensation

The esterified product produced in the esterification step is then polycondensed. The polycondensation may be carried out in one stage or in multiple stages. The polycondensation is typically carried out under reduced pressure.

After the polycondensation step the obtained resin may be pelletized or may be directly fed to a melt extruder for film formation.

### Polyester film formation

### Extrusion

After the polycondensation step, the polycondensation product is either directly fed to the melt extruder, or the polycondensate product is first pelletized and then melted in the extruder.

The melt temperature in the extruder is preferably from 250 to 320 °C, more preferably from 260 to 310°C, most preferably from 270 to 300°C. The extruder may be a single-screw extruder or a multi-screw extruder. The extruder may be purged with nitrogen to prevent the formation of terminal carboxyl groups through thermal oxidative (or thermo-oxidative) decomposition.

The melt is preferably extruded out through an extrusion die via a gear pump and a filter unit.
The extruded melt is then cooled on one or more chill rolls to form a film thereon. The temperature of the chill rolls is preferably from 5 to 80°C; more preferably from 15 to 70°C, most preferably from 20 to 60°C. When two chill rolls are used, the temperature of both may be different, for example between 5 and 25 for the first chill roll and between 30 and 60°C for the second chill roll.

To enhance the adhesion between the resin melt and the chill roll and to increase the cooling efficiency, static electricity is preferably applied to the chill roll before the melt is brought into contact therewith.

### Stretching

The extruded film is then stretched, preferably biaxially stretched, to obtain the polyester film.

The draw ratio in both the longitudinal and the lateral direction is preferably between 2 and 5. In biaxial stretching, the order of longitudinal stretching (the Machine Direction (MD) or the running direction of the film) and lateral stretching (Cross Direction (CD) or the width direction) is not specifically defined. Preferably, the longitudinal stretching is carried out first.
It is preferred that the lateral draw ratio is larger than the longitudinal draw ratio. Preferably the lateral draw ratio/ longitudinal draw ratio is from 1.05 to 1.25, more preferably from 1.10 to 1.20.
The stretching temperature is preferably from 80 to 160°C, more preferably from 85 to 155°C. It is preferred that the stretching temperature in the latter stretching, preferably the lateral stretching, is higher than the temperature in the former stretching, preferably the longitudinal stretching.

Besides this stepwise biaxially stretching method, wherein stretching in a longitudinal direction and stretching in a width direction are performed separately, a simultaneous biaxially stretching method, wherein stretching in a longitudinal direction and stretching in a width direction are performed at the same time, may also be used.

### Thermofixation

In order to complete crystal orientation and to impart flatness and dimensional stability to the biaxially stretched film, the film is preferably subjected to a heat treatment for 1 to 30 sec while the sides of the biaxially stretched film are fixed, preferably at a temperature equal or higher than the glass transition temperature (Tg) of the resin but lower than the melting temperature (Tm) thereof. Such a heat treatment is then followed by a uniform and gradual cooling to room temperature.

Such a treatment is often referred to as thermofixation.
When the thermofixation temperature is too low, the heat shrinkage of the resulting film increases. On the other hand, when the heat treatment temperature is too high, the hydrolytic stability of the resulting film decreases. Preferred thermofixation temperatures are between 160 and 250°C, more preferably between 175 and 235°C, most preferably between 200 and 225°C.

### Relaxation

In addition to and after the thermofixation, a so called relaxation treatment may be carried out. Such a relaxation treatment is preferably carried out at a temperature from 80 to 160°C, more preferably from 100 to 140°C. The degree of relaxation is from 1 to 30%, more preferably from 2 to 25 %, most preferably from 3 to 20 %.

The relaxation may be attained in the lateral or longitudinal direction of the film, or in both directions.

### Thickness of the film

The thickness of the biaxially stretched polyester film is preferably between 75 µm and 500 µm, more preferably between 100 µm and 350 µm, most preferably between 125 µm and 250 µm.
Carboxyl groups in the polyester

Carboxyl groups present in the polyester may work as an acid catalyst in the hydrolysis of polyester molecules. Such hydrolysis, for example when the polyester is kept for a certain period of time in high moisture conditions, results in a decrease of the molecular weight and therefore in a decrease of the mechanical strength of the polyester film. To obtain a sufficient hydrolysis stability of the polyester film, the carboxyl group content is preferably as low as possible.

On the other hand, carboxyl groups at the surface of the polyester film may enhance the adhesion between the polyester film and layers provided thereon. For that reason, the carboxyl group content is preferably not zero.

The carboxyl group content of the polyester film is preferably between 0 and 40 meq/kg, more preferably between 5 and 20 meq/kg.

To ensure low concentrations of carboxyl groups in the polyester film, high temperatures during the complete preparation process of the film, for example during the polycondensation process, are kept as low as possible.

To further reduce the number of carboxyl groups of the polyester, compounds that react with a carboxyl group of the polyester may be added to the polyester. Examples of such compounds include carbodiimide compounds, epoxy compounds, and oxazoline compounds.

### Carbodiimide compounds

The carbodiimide compounds may be classified into monofunctional and polyfunctional carbodiimides. Examples of monofunctional carbodiimides include N,N'-dicyclohexylcarbodiimide, 1,3-diisopropylcarbodiimide, N,N'-diisopropylphenylcarbodiimide, N,N'-dimethyl-carbodiimide, N,N'-diisobutylcarbodiimide, N,N'-dioctylcarbodiimide, t-butylisopropylcarbodiimide, N,N'-diphenylcarbodiimide, N,N'-di-t-butyl-carbodiimide, 1-(3-dimethylaminopropyl)-3-ethyl carbodiimide, and dinaphthyl carbodiimide.

Examples of commercially available carbodiimide compounds include Stabaxol I from Rheinchemie and Stablizer 7000 from Rashig, both based on N,N'-diisopropylphenylcarbodiimide.

Polyfunctional carbodiimides are typically polycarbodiimide compounds, i.e. a polymer obtained by polymerizing a carbodiimide compound. An specific example of such a polycarbodiimide is poly(1,3,5-triisopropylphenylene-2,4-dicarbodiimide) .

Examples of commercially available polymeric carbodiimides include Stabilizer 9000 from Raschig, Stabaxol P from Rheinchemie, both based on poly(1,3,5-triisopropylphenylene-2,4-dicarbodiimide). Other polymeric carbodiimides availabe from Rheinchemie are Stabaxol P100 and Stabaxol P200.

As carbodiimide compounds may generate an isocyanate-type gas through thermal decomposition, carbodiimide compounds having a high heat resistance are preferably used. It has been observed that an increase in molecular weight of polymeric carbodiimides, results in an improvement of the thermal decomposition.

### Epoxy compounds

Preferred examples of the epoxy compounds include glycidyl ester compounds and glycidyl ether compounds. Other preferred examples are those disclosed in WO2012120260 (for example Cardura E10P).

Other preferred epoxy compounds are epoxidized fatty acid esters or epoxidized fatty acid glycerides such as disclosed in US2010/0120946 paragraphs [0020] to [0067].

Still other preferred epoxy compounds are the so called chain extenders disclosed in for example US2010/0120947. Chain extenders are molecules with at least two reactive groups, preferably an epoxy group, which can react with the polyester during extrusion and join polyester chains to one another. Typically, their reactive groups are already depleted substantially (to an extent of 75 % or more) during the extrusion and are no longer available for a chain repair during the use of the polyester film after the production thereof. Preferred chain extenders are difunctional epoxides, even more preferred chain extenders are polyfunctional epoxides. The epoxy function is arranged terminally at the end of the molecule chain or of a side chain. Polyfunctional epoxides are preferred since lower amounts are required, higher molecular weight end products are formed, and lower level of gaseous cleavage products are formed. Commercially available chain extenders include polymers sold by BASF under the Joncryl ADR brand name.

### Oxazoline compounds

The oxazoline compounds are preferably bisoxazoline compounds such as 2,2'-bis(2-oxazoline), 2,2'-bis(4-methyl-2-oxazoline), 2,2'-bis(4,4'-dimethyl-2-oxazoline), 2,2'-bis(4-methyl-2-oxazoline), 2,2'-bis(4-ethyl-2-oxazoline), 2,2'-bis(4,4'-diethyl-2-oxazoline),2,2'-bis(4-propyl-2-oxazoline), 2,2'-bis(4-butyl-2-oxazoline), 2,2'-bis(4-hexyl-2-oxazoline), 2,2'-bis(4-phenyl-2-oxazoline), 2,2'-bis(4-cylcohexyl-2-oxazoline), 2,2'-bis(4-benzyl-2-oxazoline), 2,2'-p-phenylenebis(2-oxazoline), 2,2'-m-phenylenebis (2-oazoline), 2,2'-o-phenylenebis(2-oxazoline), 2,2'-p-phenylenebis(4-methyl-2-oxazoline), 2,2'-p-phenylenebis(4,4-dimethyl-2-oxazoline), 2,2'-m-phenylenebis(4,4-dimethyl-2-oxazoline), 2,2'-m-phenylenebis(4-methyl-2-oxazoline), 2,2'-m-phenylenebis(4,4-dimethyl-2-oxazoline), 2,2'-ethylenebis(2-oxazoline), 2,2'-tetramethylenebis(2-oxazoline), 2,2'-hexamethylenebis(2-oxazoline), 2,2'octamethylenebis(2-oxazoline), 2,2'-decamethylenebis(2-oxazoline), 2,2'-ethylenebis(4-methyl-2-oxazoline), 2,2'-ethylenebis(4,4-dimethyl-2-oxazoline), 2,2'-9,9'-diphenoxyethanebis(2-oxazoline), 2,2'-cyclohexylenebis(2-oxazoline) and 2,2'-diphenylenebis(2-oxazoline). Among these, 2,2'-bis(2-oxazoline) is most preferably used from the viewpoint of reactivity with the polyester.

A particularly preferred oxazoline compound is 2-Phenyl-4,5-dihydrooxazole and 4,5-Dihydro-2-phenyl-6H-1,3-oxazine.

The bisoxazoline compounds may be used individually, or two or more different compounds may be used together.

The amount of the carbodiimide compounds, the epoxy compounds, or the oxazoline compounds in the polyester film is typically from 0.1 to 5 wt %, preferably from 0.3 to 4 wt %, more preferably from 0.5 to 3 wt %, relative to the total weight of the polyester resin.

### Phosphorus compound

It is well known that phosphorus compound, added to the polyester, may also improve the hydrolytic stability of the polyester. The amount of phosphorus atoms, determined by fluorescent X-ray analysis, is preferably more than 200 ppm, more preferably more than 300 ppm, even more preferably more than 400 ppm.
The phosphorus compounds are preferably selected from the group consisting of phosphoric acid, phosphorous acid, phosphonic acid, and methyl esters, ethyl esters and phenyl esters of those acids.

The compounds mentioned above are typically added to the polyester resin in the melt extruder, before film formation. However, such compounds may also be added to the esterification of polycondensation are typically added to the polyester during the formation of a polyester film.

### UV light absorber/UV light stabilizer

To prevent degradation caused by UV light, UV light absorbers and/or UV light stabilizers may be added to the polyester film. UV light absorbers absorb UV light and convert it into heat energy, while UV light stabilizers scavange radicals generated by photodecomposition of the polyester resin and prevent further decomposition of the resin. A degradation of the polyester resin may result in a decrease of the partial discharge voltage, in a decrease of the strength of the polyester film, and in a color tone change (for example yellowing) of the polyester film.

Examples of organic UV light absorbers include salicyl acid compounds such as p-t-butylphenylsalicylate or p-octylphenyl salicylate, benzophenone compounds such as 2,4-dihydroxy benzophenone, 2-hydroxy-4-methoxy benzophenone, 2-hydroxy-4-methoxy-5-sulfo benzophenone, 2,2'4,4'-tetrahydroxy benzophenone, and bis(2-methoxy-4-hydroxy-5-benzoylphenyl)methane, benzotriazole compounds such as 2-(2'-hydroxy-5'-methylphenyl)benzotriazole and 2,2'-methylene bis[4-(1,1,3,3-tetramethylbutyl)-6-(2H-benzotriazole-2-yl)phenol], cyanoacrylate compounds such as ethyl-2-cyano-3,3'-diphenyl acrylate, triazine compounds such as 2-(4,6-diphenyl-1,3,5-triadizine-2-yl)-5-[(hexyl)oxy]-phenol (Tinuvin 1577) and 2-(2-Hydroxy-4-(2-ethylhexyl)oxyphenyl)-4,6-di(4-phenylphenyl)-1,3,5-triazine (Tinuvin 1600) and, 2-[4-[4,6-bis([1,1'-biphenyl]-4-yl)-1,3,5-triazin-2-yl]-3-hydroxyphenoxy]-propanoic acid isooctyl ester (Tinuvin 479).

Examples of UV light stabilizers are hindered amine compounds such as bis(2,2,6,6-tetramethyl-4-piperidyl)sebacate and the polycondensate of dimethylsaccinate and 1-(2-hydroxyethyl)-4-hydroxy-2,2,6,6-tetramethyl piperidine.

The content of the UV light absorber or UV light stabilizer in the polyester resin composition is preferably from 0.1 to 10 wt %, more preferably from 0.3 to 7 wt %, even more preferably from 0.7 to 4 wt %.

### Other additives

It is preferred to add inorganic particles to the polyester to optimize properties as slipperiness, abrasion resistance, scratch resistance of the surface of the polyester film. Examples of inorganic particles are for example particles of clay, mica, titanium oxide, calcium carbonate, kaolin, talc, silica, calcium phosphate, barium sulfate, alumina, and zirconia.
Preferred inorganic particles are silica and alumina. The amount of silica and/or alumina is preferably between 0.025 and 1.500 wt %, more preferably between 0.050 and 1.000 wt %.

Optical brighteners such as 2,5-thiophenediylbis(5-tert-butyl-1,3-benzoxazole) (Uvitrex OB, Benetex OB Plus) may also be added to the polyester.

### Master batch technology

It is preferred that additives such as inorganic particles, UV light absorbing compounds, additives to improve the hydrolytic resistance are added to the polyester resin by means of a so called master batch. To prepare such a master batch, the additive is first dispersed in a carrier material. The carrier material is preferably polyester, but it may be another polymer which is compatible with polyester. The master batch is added to the polyester in the melt extruder, before film production, resulting in the components of the master batch being dissolved or finely dispersed in the polyester.

### Thermal shrinkage of the polyester

The thermal shrinkage of the polyester is evaluated by measuring the length in the MD and the CD of an A4 sheet of PET after holding the sheet at 150°C for 30 minutes, and compare it to the initial lengths (in %). The thermal shrinkage in the MD is preferably between 0 and 1.5 %, preferably between 0.05 and 1.0 %, most preferably between 0.1 and 0.6 %. The thermal shrinkage in the CD is preferably between 0 and 1.0 %, preferably between 0.05 and 0.6 %, most preferably between 0.1 and 0.3 %.

### Surface treatment

The polymeric support may be surface treated, typically to enhance the adhesion between the support and layers provided thereon.

Examples of such a surface treatment include a corona discharge treatment, a flame treatment, an UV treatment, a low pressure plasma treatment, and an atmospheric plasma treatment. A chemical treatment of the surface is also known in the art.

In a corona discharge treatment, typically high frequency and high voltage electricity is applied between a metal roll coated with a dielectric substance and insulated electrodes to induce ionization of the air between the electrodes, i.e. a corona discharge. A corona discharge treatment of the support is performed by passing the support through the corona discharge. Coronization may also been performed in modified atmospheric conditions.

For example, a gap distance between the electrodes and the dielectric roll may be from 1 to 3 mm, a frequency of 1 to 100 kHz, and an applied energy of 0.2 to 5 kV.A.min/m² may be used.

In a flame treatment, the outer flame portion of a flame is brought into contact with the support. Care has to be taken that the flame, uniformly hits the support surface. This may be achieved by using plural, circular-shaped burners. Examples of the combustion gas that may be used in a flame treatment include paraffin-based gases such as natural gas, methane gas, ethane gas, propane gas and butane gas, and olefin-based gases such as ethylene gas, propylene gas, and acetylene gas. These gases may be used singly, or as mixtures of two or more gases. Oxygen or air is preferably used as an oxidizing gas that is mixed with the combustion gas.
A flame treatment as disclosed in US2011/0284075, paragraph [0247] to [0258] is preferably used to optimize the surface energy of the polymeric support.

In an UV treatment, the surface of a support is irradiated with UV radiation to improve its adhesiveness and wettability. Typically, a low pressure mercury UV lamp is used as an UV radiation source. Preferably UV radiation at 254 nm, more preferably at 185 nm is used in such a UV treatment. The UV treatment is typically carried out for 1 to 500 seconds under atmospheric pressure.

In a low pressure plasma treatment, the surface of the support is treated with plasma, generated as a result of a discharge in a gas, the plasma gas, in a low pressure atmosphere. Examples of plasma gas that may be used include oxygen gas, nitrogen gas, water vapor gas, argon gas and helium gas. Preferably oxygen, or a mixed gas of oxygen gas and argon gas, are used. The pressure of the plasma gas is preferably in the range of 0.005 to 10 Torr, more preferably in the range of 0.008 to 3 Torr. The plasma output power is preferably from 100 to 2500 W, more preferably from 500 to 1500 W. The treatment time is preferably from 0.05 to 100 seconds, more preferably from 0.5 to 30 seconds. The plasma may be generated using a direct current glow discharge, a high frequency wave discharge, or a microwave discharge.

In an atmospheric pressure plasma treatment, a stable plasma discharge is generated at atmospheric pressure using high frequency waves. Argon gas or helium gas may be used as carrier gas. Oxygen gas may be mixed with the carrier gas. The atmospheric pressure plasma treatment is preferably carried out at atmospheric pressure or a pressure close to or below the atmospheric pressure, such as between 500 and 800 Torr. The power supply frequency of the discharge is preferably 1 to 100 kHz, more preferably 1 to 10 kHz. The discharge intensity is preferably from 50 to 500 W.min/m².

### Functional layers

The polyester film is provided with at least one functional layer, i.e. the weather resistant layer. However, other functional layers may also be provided, for example a primer to enhance the adhesion towards an EVA encapsulant on one side of the polyester film and/or a primer to enhance the adhesion towards the weather resistant layer on the other side of the polyester film. These functional layers can be applied after uniaxial and/or biaxial stretching of the polyester film.

Known coating techniques such as roll coating, knife coating, gravure coating, or curtain coating may be used.

The functional layers may be applied from water based or solvent based coating solutions, preferably from water based solutions.

### Primer to the encapsulant

The surface of the polymeric support may be provided with a primer or adhesive layer to improve the adhesion of the back sheet to the encapsulant or sealing material. The back sheet then comprises the weather resistant layer on one side of the support and a primer (11) on the other side of the support to enhance the adhesion of the back sheet towards an encapsulant layer (2').

The primer may comprise a binder. The binder may be selected from polyolefins, polyesters, acrylic resins and polyurethanes. The binder may also be a composite resin of acrylic polymer and silicone. Examples of such binders are Chemipearl S-120 and S-75N, both polyolefins from Mitsui Cemicals, Jurymer ET-410 and SEK-301, both acrylic resins from Nihon Junyaku, Ceranate WSA1060 and 1070, both composite resins of an acrylic polymer and silicone from DIC, and H7620, H7630, and H7650, all composite resins of an acrylic polymer and silicone from Asahi Kasei Chemicals.

The amount of binder is typically from 0.05 to 5.00 g/m², more preferably from 0.08 to 3.00 g/m².

The primer may also comprise crosslinking agents, selected from epoxy compounds, isocyanate compounds, melamine compounds, carbodiimide compounds and oxazoline compounds. Examples of oxazoline compounds are disclosed WO2011/118844 paragraph [0058]-[0060]. Commercially available oxazoline compounds are for example EPOCROS K2010E, K2020E, WS-500, WS-700 all available from Nippon Shokubai.

EP-A 2479026 discloses a preferred polyurethane based primer wherein the polyurethane has a polycarbonate or a polyether skeleton and wherein the primer further comprises a crosslinking agent. Preferred crosslinking agents are oxazoline and carbodiimide compounds. The polyurethane is preferably used in the form of a dispersion or a solution having water as medium. For that reason, the crosslinking agents are also preferably water-soluble or water-dispersible.

It has been observed that a crosslinkable fluorpolymer, such as those described below for the weather resistant layer, may also be used as binder for the primer towards the encapsulant.

The primer may contain inorganic fine particles. These may be selected from silica, calcium carbonate, magnesium oxide, magnesium carbonate, and tin oxide. Tin oxide and silica are preferred.
The particle size of the inorganic particles is preferably from 10 to 700 nm, more preferably from 20 to 300 nm.
The amount of these inorganic particles is preferably between 5 and 400 wt %, more preferably between 10 and 300 wt %, relative to the binder.

The primer may also contain matting agents, such as polystyrene, poly(methyl methacrylate) or polyamide matting agents.

The primer may also contain a surfactant, such as an anionic or nonionic surfactant.

The primer is preferably applied on the polymeric support by coating a coating liquid on the support. Any known coating method, such as gravure coating, roll coating, bar coating, knife coating or curtain coating may be used.

The coating solvent may be water or an organic solvent, such as for example MEK, ethyl acetate, or butyl acetate.

The thickness of the primer is preferably between 0.05 and 8 *µ*m, more preferably between 0.1 and 5 *µ*m. The primer may consist of one layer or of two or more layers.

The surface of the support on which the primer is applied may be surface treated, as described above, to improve the adhesion of the primer (and the encapsulant) to the polymeric support.

The coating solution of the primer may be applied on the polymeric support before or after the support has been biaxially stretched or, more preferably, in between the longitudinal and lateral stretching.

### Weather resistant layer

The weather resistant layer comprises a binder containing a crosslinkable group. Such a crosslinkable group is also referred to as a functional group or a curable group.

Binder having a crosslinkable group

The crosslinkable group of the binder is a hydroxyl group.

In a preferred embodiment, the binder is a fluorine-based polymer having a crosslinkable group such as disclosed in for example EP-A 1938967, WO2007072826 and EP-A 2309551.

Examples of curable groups that may be introduced into the fluorine-based polymers are for example hydroxyl, carboxyl, amino, glycidyl, silyl, silanate, a 1,3-dicarbonyl group (e.g. aceto acetoxy methacrylate of diacetone acrylamide), and isocyanate groups. Preferred curable groups are hydroxyl groups.

The curable groups are introduced into the fluorine-based polymers by copolymerizing a fluoro-olefin with a monomer containing a curable group.

The fluoro-olefin may tetrafluoro ethylene (TFE), chlorotrifluoro ethylene (CTFE), hexafluoro-propylene, vinyl fluoride, or vinylidene fluoride. Among these, TFE and CFTE are particularly preferred from the viewpoint of weatherability and solvent resistance of the coated layer. One type of fluoro-olefin may be used or two or more types may be used in combination. As the proportion of fluoro-olefin monomers in the fluoropolymer becomes larger, the weatherability of the coated film will improve. On the other hand, when it becomes smaller, the solubility of the fluoropolymer will improve. The proportion of fluoro-olefin monomer is preferably between 30 to 70 mol %, more preferably between 40 and 60 mol %.

Examples of hydroxyl-containing monomers are hydroxyl-containing vinyl ethers such as 2-hydroxyethyl vinyl ether, 3-hydroxypropyl vinyl ether, 2-hydroxy-2-methylpropyl vinyl ether, 4-hydroxybutyl vinyl ether, 4-hydroxy-2-methylbutyl vinyl ether, 5-hydroxypentyl vinyl ether and 6-hydroxyhexyl vinyl ether, hydroxyl-containing allyl ethers such as 2-hydroxyethyl allyl ether, 4-hydroxybutyl allyl ether and glycerol monoallyl ether, or hydroxyalkyl esters of (meth)acrylic acids such as 2-hydroxyethyl acrylate and 2-hydroxyethyl methacrylate. Other examples are disclosed in EP2309551, paragraph [0024]-[0026]. Among these, hydroxyl-containing vinyl ethers, especially 4-hydroxybutyl vinyl ether and 2-hydroxyethyl vinyl ether are particularly preferred.

The hydroxyl group content of the fluoropolymer is preferably between 30 and 200 mg KOH/g, more preferably between 40 and 150 mg KOH/g.

Examples of carboxyl-containing monomers, of amino-containing monomers, and of silyl-containing monomers are those disclosed in EP-A 1938967, [0028]-[0032] and EP2309551, paragraph [0028]-[0036].

Besides the fluoro-olefin and the monomer containing the curable group, other monomers may be incorporated in the fluoropolymer. Preferred monomers have a C₂₋₂₀ linear or branched alkyl group and a polymerizable unsaturated group linked to each other by an ether or an ester bond. Examples of such monomers are disclosed in EP2309551, paragraph [0059]-[0077].

Other preferred monomers that may be used in combination with the monomers described above are for example ethylene, propylene, n-butene, isobutene, or vinyl benzoate.

Commercially available TFE fluropolymers are for example Zeffle GK polymers from DAIKIN INDUSTRIES. Commercially available CTFE fluoropolymers are for example LUMIFLON polymers from ASAHI GLASS.

In another preferred embodiment, the binder is an acrylic resin comprising crosslinkable groups. Such polymers are typically copolymers of alkyl (meth) acrylate monomers and hydroxyl containing (meth)acrylate monomers. Preferred monomers are methyl (meth)acrylate, butyl(meth)acrylate and hydroxyethyl (meth)acrylate. Such acrylic resins are for example the commercially available Degalan® acrylic resins from EVONIK.

EP-A 2416381 discloses an acrylic polyol that may also be used in the weather resistant layer of the present invention. The acrylic polyol is obtained by copolymerizing an acrylic monomer containing a hydroxyl group and another monomer containing an unsaturated double bond. The acrylic polyol may also comprise an ultraviolet stabilizing group, preferably a Hindered Amine Light Stabilizing (HALS) compound, and/or an ultraviolet absorbing group. Such copolymers may be obtained by copolymerizing HALS-containing monomers and/or UV absorbing monomers with the acrylic polyol monomers. Preferred HALS containing monomers and UV absorbing compounds are those disclosed in EP-A 2416381, paragraph [0034] and [0035] respectively.

Commercially available acrylic polyol containing a UV absorbing compound and a HALS compound are the HALSHYBRID UV-G series from Nippon Shokubai.

Other binders that may be used are selected from polyether polyols, polyester polyols, and polycarbonate diols.

Also, a mixture of both aforementioned reactive binders may be used.

Moreover, in addition to a reactive binder having a crosslinkable group, binders having no reactive group may also be added to the weather resistant layer.

### UV light absorbers - UV light stabilizers

To protect the support from UV light, the weather resistant layer preferably comprises an UV light absorber and/or an UV light stabilizer/

An UV light absorbing compound absorbs at least part of the UV light that reaches the weather resistant layer.

The UV light absorbing compound may be organic or inorganic UV absorbing compounds.

The UV light absorbing compounds and UV light stabilizers that may be added to the polyester support (see above) may also be used in the weather resistant layer.

Preferred UV light absorbing compounds are Ti0₂ particles, ZnO particles and mixtures thereof.

The particle size of these inorganic UV absorbing compounds is preferably between 0.01 and 5.00 µm, more preferably between 0.10 and 2.50 µm, most preferably between 0.20 and 1.00 µm

The amount of the inorganic UV absorbing particles is preferably between 2.5 and 20 g/m², more preferably between 5 and 15 g/m².

The outer layer may also comprise a surfactant and a filler, such as for example colloidal silica.

The total dry coating weight of the weather resistant layer is preferably between 5 and 75 g/m², more preferably between 10 and 50 g/m², most preferably between 15 and 35 g/m².

### Crosslinking agents

The crosslinking agents are isocyanate compounds. Standard commercial polyisocyanates are all derived from just a few diisocyanates with aliphatic, alicyclic (or cyclic aliphatic) or aromatic isocyanate groups.

The most important diisocyanates that are available on an industrial scale are summarized in the table below.

| Chemical Formula | Chemical name |
|---|---|
| 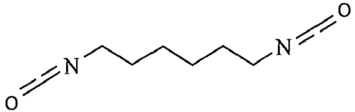 | Hexamethylene diisocyanate (HDI) |
| 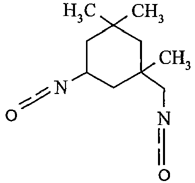 | Isophorone diisocyanate (IPDI) |
| 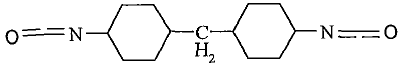 | Bis(4-isocyanatocyclohexyl)methane (H12MDI) |
| 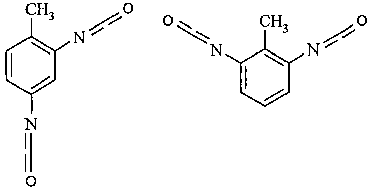 | 2,4 and 2,6-toluene diisocyanate (TDI) |
| 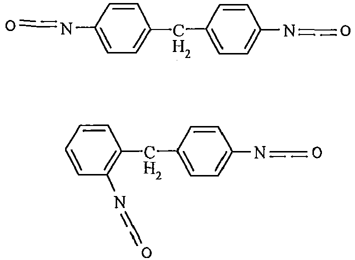 | Diphenylmethane-4,4' and/or - 2,4'-diisocyanate (MDI) |
| 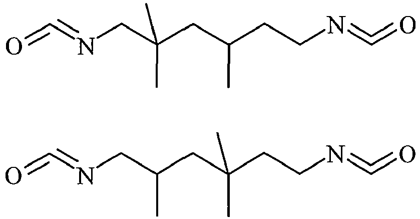 | 2,2,4- and 2,4,4-trimethylhexamethylene diisocyanate (TMDI) |
| 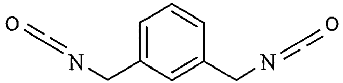 | meta-xylylenediisocyanate (XDI) |
| 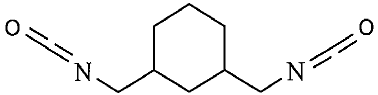 | Hexahydro-meta-xylylenediisocyanate (1,3-H6XDI) |
| 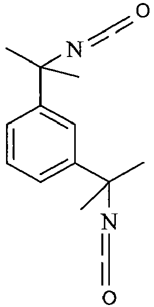 | Tetramethyl-meta-xylylene diisocyanate (TMXDI) |

With the exception of MDI, the diisocyanate compounds of the table above are classified as toxic substances. For this reason, and also to increase the functionality, the diisocyanates are converted to polyisocyanates. Polyisocyanates with a functionality greater than 2 makes spatial crosslinking possible.

The manufacturing process for making these polyisocyanate compounds results in oligomer mixtures exhibiting a molecular weight distribution. This makes it possible to optimize the products towards viscosity, isocyanate functionality, etc.

Aliphatic polyisocyanate compounds may be derived from HDI and TMDI, alicyclic polyisocyanate compounds are derived from IPDI, H12MDI, and 1,3-H6XDI, and aromatic polyisocyanate compounds are derived from TDI, MDI, XDI and TMXDI.

Prepolymers based on aliphatic or aromatic diisocyanates may also be used. These products are obtained by reacting such diisocyanates with long-chain polyols, especially polyether polyols.

The weather resistant layer according to the invention comprises in addition to an aliphatic isocyanate crosslinking agent, an aromatic or an alicyclic isocyanate crosslinking agent.

Both an aromatic isocyanate crosslinking agent and an alicyclic isocyanate crosslinking agent may be present in addition to the aliphatic isocyanate crosslinking agent.

The molar ratio of the isocyanate groups of the aliphatic isocyanate crosslinking agents to the isocyanate groups of the aromatic and/or alicyclic crosslinking agents is ≤ 3.00, more preferably between 0.05 and 3.00, most preferably between 0.1 and 2.75, particularly preferred between 0.2 and 2.50.

The molar ratio of the isocyanate groups of all the isocyanate crosslinking agents and the crosslinkable groups, preferably the hydroxyl groups, of the binder ([NCO]/[OH]) is preferably between 0.25 to 2.5, more preferably between 0.50 and 1.75, most preferably between 0.75 and 1.50. It has been observed that the molar ratio [NCO]/[OH] is preferably higher for aqueous layers than for solvent based layers probably because water may react with NCO groups, making them unavailable for the crosslinking reaction.

The binder with the reactive groups, and the polyisocyanate compounds according to the present invention may be added together to the coating solution of the weather resistant layer. However, crosslinking may then already start in the coating solution and might result in a viscosity increase of the coating solution with time. The pot life of the coating solution has to be taken into account.

To avoid crosslinking in the coating solution, the polyisocyanate compounds may be added to the coating solution at the time of coating.

### Catalyst

Catalysts may be added to improve the crosslinking efficiency. Well known catalysts are for example dibutyl tin dilaurate (DBTL) or dioctyl tin laurate. Such a catalyst may be added to the coating solution, but to increase the pot life of the coating solution, it is preferred that the catalyst is added at the time of coating.

Tin free catalysts are for example: the bismuth based catalysts Borchi® Kat 0244 and Borchi® Kat 315 from Borchers and Dabco® MB20 from Air Products; and the zinc based catalysts K-KAT-XK-622 and XK-614 from King Industries

The amount of catalyst depends on the type of catalyst but is preferably between 0.005 and 3.00 wt % relative to the total amount of binder, more preferably between 0.01 and 1.00 wt %, most preferably between 0.025 and 0.50 wt %.

The weather resistant layer may be coated from an aqueous or non-aqueous coating solution.

When a solvent based coating solution is used, preferred solvents are Methyl Ethyl Ketone (MEK), n-butylacetate, and ethylacetate.

When an aqueous coating solution is used, organic solvents may be mixed with water to improve the solubility of the ingredients. Examples of such solvents are acetone, methoxypropanol and glycolethers.

### Primer to the weather resistant layer

A primer may be provided between the polymeric support and the weather resistant layer to improve the adhesion between both.

The thickness of such a primer is preferably less than 2 µm, more preferably between 0.05 and 2.00 µm, even more preferably between 0.1 and 1.50 µm.

The primer may contain a binder, for example polyesters, polyurethanes, acrylic resins, or polyolefins. Apart from the binder, the primer may also contain compounds selected from epoxy compounds, isocyanate compounds, melamine compounds, carbodiimide compounds and oxazoline compounds, a surfactant selected from anionic and nonionic surfactants, or a filler, such as silica.

The coating method for the primer may be any conventional coating method, for example a gravure coater of a bar coater may be used.

The coating solvent of the coating solution may be water or an organic solvent such as toluene or MEK. One or more solvents may be used singly or in combination.

The coating solution may be applied on the polymeric support before or after the support has been biaxially stretched or, more preferably, in between the lateral and longitudinal stretching.

### Solar Cell Module

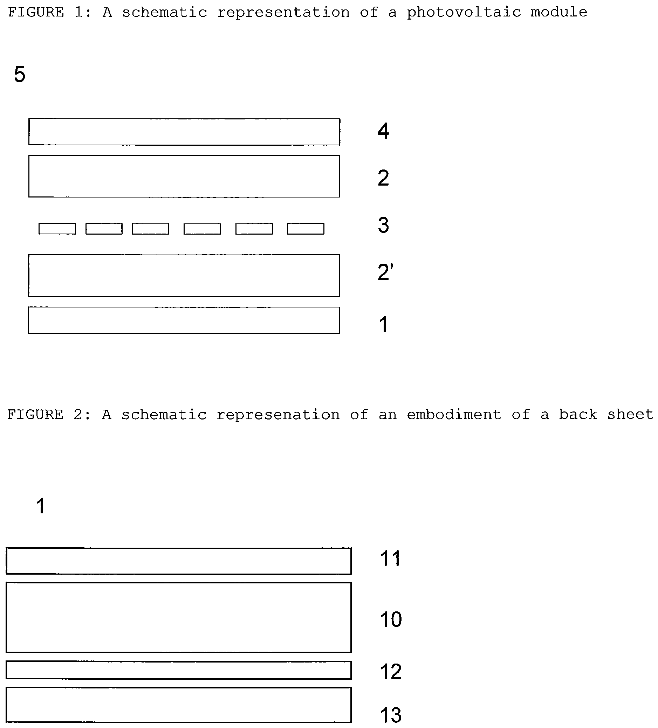

Figure 1 schematically represents an embodiment of a photovoltaic module according to the present invention.

The solar cell module (5) has a configuration in which a solar cell element (3), which converts the light energy of sunlight to electrical energy, is disposed between a transparent sheet (4) through which sunlight enters (also referred to as the front sheet) and the back sheet (1) according to the present invention. The solar cell element (3) is encapsulated by an encapsulant or sealing layer (2, 2').

Such a solar cell module is typically prepared by laminating all components, i.e. back sheet, front sheet, encapsulant sheets and the solar cell element, in one step.

A preferred embodiment of a back sheet (1) according to the present invention is schematically represented in Figure 2.
The back sheet (1) comprises a polymeric support (10), on one side of the support an optional primer (12) and a weather resistant layer (13), and a primer (11) on the other side of the support to enhance the adhesion towards an encapsulant layer (2').

To simplify the assembly of a solar cell module by the module manufacturer, it may be preferred to integrate the back sheet (1) and the encapsulant layer (2').

Such an integration may have a positive influence on the cost price of the solar cell module.

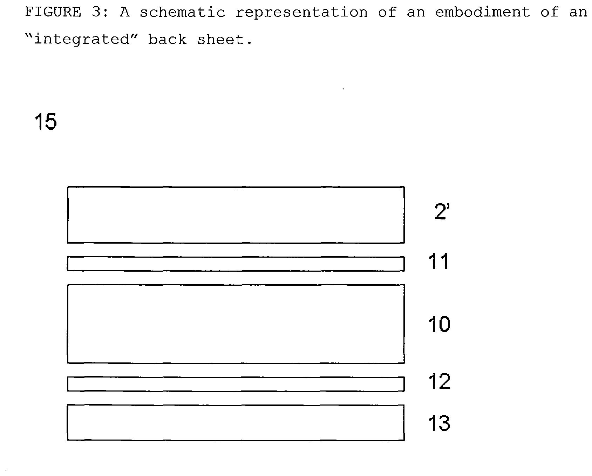

Figure 3 schematically represents an embodiment wherein the back sheet according to the present invention (1) is integrated with an encapsulant layer (2'). The encapsulant layer (2') may be applied to the back sheet (1) by a laminating an encapsulant layer on the back sheet or by extrusion coating an encapsulant layer on the back sheet.

### EXAMPLES

### Materials

All materials used in the examples were readily available from standard sources such as Aldrich Chemical Co. (Belgium) and Acros (Belgium) unless otherwise specified.

Zeffle GK570, a fluorine containing polymer from DAIKIN.

Ti0₂, TiPure R-706, a Ti0₂ grade from DUPONT DE NEMOURS.

Desmodur N3300, an aliphatic polyisocyanate (oligomer containing HDI trimer) from BAYER.

Desmodur N3790, an aliphatic polyisocyanate (high functional HDI trimer) from BAYER.

Suprasec 2496, an aromatic polysisocyanate (MDI based) from HUNTSMAN.

Vestanat T1890E, a cycloaliphatic polyisocyanate based on isophorone diisocyanate from EVONIK Degussa.

Tolonate IDT70B, a cycloaliphatic polyisocyanate based on isophorone diisocyanate from PERSTORP.

### Example 1

All samples contain a fixed amount of Zeffle GK570 and Ti0₂. Zeffle GK570 was added to the coating solution as a 65 wt % solution in n-butylacetate. Ti0₂ was added as a 66.7 wt % dispersion in 33.3 wt % Zeffle GK570 (50 g TiPure, 25 g Zeffle GK570 and butylacetate until 100 g dispersion).
The isocyanate compounds were added as a 30 wt % solution in n-butylacetate. Methyl ethyl ketone (MEK) and n-butylacetate were used as coating solvent.

The reactive, crosslinkable groups of the Zeffle GK-570 binder are hydroxyl groups. To obtain a fair comparison between the different isocyanate compounds, their amount was adjusted to obtain a fixed molar ratio of isocyanate groups to hydroxyl groups. The molar ratio [NCO]/[OH] was kept at 1.1/1. In the calculation it was taken into account that the Zeffle GK570 polymer contains 60 mg KOH/g polymer.

The coating solutions were hand coated on a coronized PET substrate using a Baker coating applicator. The wet coating thickness was 50 µm. The coating was air dried for 20 seconds and then put into an oven at 120 °C for 10 minutes. To minimize the amount the amount of residual NCO groups, the coating was then kept overnight at 90 °C for another 15 hours.

In this example, aliphatic (Desmodur N3300 and Desmodur N3790) and aromatic (Suprasec 2496) isocyanate compounds are evaluated. Table 1 shows the composition (dry weight g/m²) of the coated samples.

To calculate the amount of the isocyanate compounds to arrive at a molar ratio [NCO]/[OH] of 1.1/1, it was taken into account that Desmodur N3300 contains 21.80 g NCO/100 g; Desmodur N3790 contains 17.80 g NCO/100 g; and Suprasec 2496 contains 31.30 g NCO/100 g.

The ratios [NCO]_{DN3300}/[NCO]_{S2496} and [NCO]_{DN3790}/[NCO]_{S2496} referred to in Table 1 are the molar ratio of the NCO groups of respectively Desmodur N3300 and Desmodur N3790 to the NCO groups of Suprasec 2496.

**Table 1**

| Ingredients (g/m²) | INV01 | INV02 | INV03 | COMP04 | COMP05 | INV04 | |
|---|---|---|---|---|---|---|---|
| Zeffle GK-570 | 12.40 | = | = | = | = | = | |
| Ti0₂ | 9.50 | = | = | = | = | = | |
| Desmodur N3300 | 1.41 | 1.97 | 2.11 | 2.25 | 2.53 | - | |
| Desmodur N3790 | - | - | - | - | - | 1.72 | |
| Suprasec 2496 | 0.98 | 0.59 | 0.49 | 0.39 | 0.20 | 0.98 | |
| [NCO] _{DN3300}/ [NCO] _{S2496} | 50/50 | 70/30 | 75/25 | 80/20 | 90/10 | - | |
| [NCO] _{DN3790}/ [NCO]_{S2496} | - | - | - | - | - | 50/50 | |
| Ingredients (g/m²) | INV05 | INV06 | COMP06 | COMP07 | COMP01 | COMP02 | COMP03 |
| Zeffle GK-570 | 12.40 | = | = | = | = | = | = |
| Ti0₂ | 9.50 | = | = | = | = | = | = |
| Desmodur N3300 | - | - | - | - | - | 2.82 | - |
| Desmodur N3790 | 2.41 | 2.59 | 2.76 | 3.10 | - | - | 3.45 |
| Suprasec 2496 | 0.59 | 0.49 | 0.39 | 0.20 | 1.96 | - | - |
| [NCO] _{DN3790}/ [NCO]_{S2496} | 70/30 | 75/25 | 80/20 | 90/10 | - | - | - |

First, the visual quality of the coatings was determined. It was performed after the initial curing and the coating was reported as either OK or not OK depending on its visual appearance, i.e. glossiness, presence of defects (orange peel, fish eyes, pinholes, runs, cracking, peeling and so on) and brittleness. All these factors indicated the compatibility of ingredients with each other and the ease of spreading.

Stickiness of the coatings.

The coatings were air dried for 20 seconds and then cured at 120 °C for 30 seconds. A 5 cm x 5 cm PET substrate was pressed on the coated layer with roller. The substrate was then slowly peeled off from the coated layer.

The noise associated with the peeling off was evaluated as shown in Table 2.

**Table 2**

| Level | sound |
|---|---|
| 0 | No noise |
| 1 | Very light static |
| 2 | Light static |
| 3 | Static-like noise |
| 4 | Crackling noise |
| 5 | Very loud crackling noise |

The amount of the coating that was removed by peeling off the substrate was evaluated as shown in Table 3.

**Table 3**

| Level | Coating removed |
|---|---|
| 0 | Coating intact, no damage |
| 1 | Coating very slightly damaged, a small piece of the coating was ripped off |
| 2 | Coating slightly damaged, a few pieces of the coating were ripped off |
| 3 | Coating was damaged, a few big pieces of the coating were ripped off |
| 4 | Coating was quite heavy damaged, large areas of the coating were ripped off |
| 5 | Coating was almost completely ripped off |

The overall stickiness ranking was carried out as shown in Table 4, i.e. the highest number/level of both was taken as overall stickiness value.

**Table 4**

| Noise Level Removal level | 0 | 1 | 2 | 3 | 4 | 5 |
|---|---|---|---|---|---|---|
| 0 | 0 | 1 | 2 | 3 | 4 | 5 |
| 1 | 1 | 1 | 2 | 3 | 4 | 5 |
| 2 | 2 | 2 | 2 | 3 | 4 | 5 |
| 3 | 3 | 3 | 3 | 3 | 4 | 5 |
| 4 | 4 | 4 | 4 | 4 | 4 | 5 |
| 5 | 5 | 5 | 5 | 5 | 5 | 5 |

An overall stickiness level of 0-2 was considered acceptable, while any ranking above 2 was considered unaccaptable.

### Adhesion testing

After overnight curing (90°C; 15 hours) the coatings were tested for adhesion using the Cross-Hatch test. Additionally, the wet adhesion was also tested wherein the coating was placed in a water bath for 24 hours at 85°C before carrying out the Cross-Hatch test. The adhesion was ranked using the BS/ISO/DIN reporting system, i.e. from 0 to 5 wherein 0 - 2 is considered an acceptible adhesion and 2 - 5 a bad adhesion.
The adhesion, dry and wet, was OK for all samples. The overall stickiness results are shown in Table 5.

**Table 5**

| | [NCO] _{DN3300}/ [ NCO] _{S2496} | [NCO] _{DN3790}/ [NCO]_{S2496} | Overall Stickiness |
|---|---|---|---|
| INV01 | 50/50 | - | 0 |
| INV02 | 70/30 | - | 0 |
| INV03 | 75/25 | - | 1 |
| COMP04 | 80/20 | - | 3 |
| COMP05 | 90/10 | - | 4 |
| INV04 | - | 50/50 | 0 |
| INV05 | - | 70/30 | 1 |
| INV06 | - | 75/25 | 1 |
| COMP06 | - | 80/20 | 3 |
| COMP07 | - | 90/10 | 3 |
| COMP01 | 0/100 | - | 0 |
| COMP02 | 100/0 | - | 5 |
| COMP03 | - | 100/0 | 4 |

It is clear from Table 5 that the overall stickiness of the coatings comprising only an aliphatic isocyanate crosslinking agent was not OK (COMP02 and COMP03).
On the other hand, the coating comprising only an aromatic crosslinking agent was very good for stickiness (COMP01). However, as can be seen from Example 2, coatings with only aromatic isocyanate crosslinking agents are not OK with respect to yellowing (UV resistance) and therefore not suitable for a weather resistant outer layer (see Example 2).

When a mixture of aliphatic isocyanates and aromatic isocyanates is used, the stickiness becomes better. When the molar ratio of the isocyanate groups of the aliphatic isocyanate crosslinking agent to the isocyanate groups of the aromatic crosslinking agent is ≤ 3 (see Inventive examples and COMP04 to COMP07) the stickiness becomes acceptible.

### Example 2.

In this example, samples comprising aromatic isocyanate crosslinking agents were evalauted with respect to yellowing.

The coatings were performed as in Example 1. The composition of the coatings are shown in Table 6.

To calculate the amount of the isocyanate compounds to arrive at a molar ratio [NCO]/[OH] of 1.1/1, it was taken into account that

Desmodur N3300 contains 21.80 g NCO/100 g; Desmodur N3790 contains 17.80 g NCO/100 g; and Suprasec 2496 contains 31.30 g NCO/100 g.

**Table 6**

| Ingredients (g/m²) | COMP01 | INV05 | COMP06 | COMP07 |
|---|---|---|---|---|
| Zeffle GK-570 | 12.40 | = | = | = |
| Ti0₂ | 9.50 | = | = | = |
| Desmodur N3790 | - | 2.41 | 2.76 | 3.10 |
| Suprasec 2496 | 1.96 | 0.59 | 0.39 | 0.20 |
| [NCO] _{DN3790}/ [NCO]_{S2496} | 0/100 | 70/30 | 80/20 | 90/10 |

The coatings were kept for 7 days in a Xe weatherometer in conditions in accordance with IS018930. Color changes during storage were evaluated by CIE ΔE (1976) and the Yellowness Index YI₃₁₃ (ASTM E313). The gloss was evaluated at different angels in accordance with ASTMD523 (specular gloss).

The results are shown in Table 7.

**Table 7**

| | ΔE | YI₃₁₃ | Δ YI₃₁₃ | Gloss (20°) | Gloss (60°) |
|---|---|---|---|---|---|
| COMP01 | 2.87 | 2.56 | 4.36 | 51.5 | 75.5 |
| INV05 | 0.32 | -2.48 | 0.10 | 69.6 | 81.9 |
| COMP06 | 0.39 | -2.37 | -0.02 | 67.9 | 82.6 |
| COMP07 | 0.13 | -2.36 | 0.10 | 66.2 | 80.7 |

It is clear from the results of Table 7 that the coating with 100 % suprasec 2496, the aromatic isocyanate crosslinking agent (COMP01) does show a yellowing. This was also very clear from a visual inspection of the coatings. When part of the aromatic isocyanate crosslinking agent is replaced by an aliphatic one, the yellowing becomes better.

### Example 3

In this example, aliphatic (Desmodur N3300 and N3790) and alicyclic (Vestanat T1890E) isocyanate crosslinking agents are evaluated.

The coatings were performed as in Example 1. The composition of the coatings are shown in Table 8.

To calculate the amount of the isocyanate compounds to arrive at a molar ratio [NCO]/[OH] of 1.1/1, it was taken into account that Desmodur N3300 contains 21.80 g NCO/100 g; Desmodur N3790 contains 17.80 g NCO/100 g; and Vestanat T1890E contains 12.00 g NCO/100 g.

The ratios [NCO]_{DN3300}/ [NCO]_{VT1890E} and [NCO]_{DN3790}/[NCO]_{VT1890E} referred to in Table 8 are the molar ratio of the NCO groups of respectively Desmodur N3300 and Desmodur N3790 to the NCO groups of Vestanat T1890E.

**Table 8**

| Ingredients (g/m²) | INV07 | INV08 | INV09 | COMP08 | COMP09 | INV10 | |
|---|---|---|---|---|---|---|---|
| Zeffle GK-570 | 12.40 | = | = | = | = | = | |
| Ti0₂ | 9.50 | = | = | = | = | = | |
| Desmodur N3300 | 1.41 | 1.97 | 2.11 | 2.25 | 2.53 | - | |
| Desmodur N3790 | - | - | - | - | - | 1.72 | |
| Vestanat T1890E | 2.56 | 1.53 | 1.28 | 1.02 | 0.51 | 2.56 | |
| [NCO] _{DN3300}/ [NCO] _{VT1890E} | 50/50 | 70/30 | 75/25 | 80/20 | 90/10 | - | |
| [NCO] _{DN3790}/ | - | - | - | - | - | 50/50 | |
| [NCO]_{VT1890E} | | | | | | | |

| Ingredients (g/m²) | INV11 | INV12 | COMP10 | COMP11 | COMP12 | COMP02 | COMP03 |
|---|---|---|---|---|---|---|---|
| Zeffle GK-570 | 12.40 | = | = | = | = | - | - |
| Ti0₂ | 9.50 | = | = | = | = | - | - |
| Desmodur N3300 | - | - | - | - | - | 2.82 | - |
| Desmodur N3790 | 2.41 | 2.59 | 2.76 | 3.10 | - | - | 3.45 |
| Vestanat T1890E | 1.53 | 1.28 | 1.02 | 0.51 | 5.12 | - | - |
| [NCO] _{DN3790}/ [NCO] _{VT1890E} | 70/30 | 75/25 | 80/20 | 90/10 | - | - | - |

Adhesion and stickiness tests were carried out as in Example 1. The adhesion, dry and wet, was OK for all samples. The overall stickiness results are shown in Table 9.

**Table 9**

| | [NCO]_{DN3300}/ [NCO] _{VT1890E} | [NCO] _{DN3790}/ [NCO] _{VT1890E} | Overall Stickiness |
|---|---|---|---|
| INV07 | 50/50 | - | 1 |
| INV08 | 70/30 | - | 2 |
| INV09 | 75/25 | - | 2 |
| COMP08 | 80/20 | - | 3 |
| COMP09 | 90/10 | - | 4 |
| INV10 | - | 50/50 | 1 |
| INV11 | - | 70/30 | 1 |
| INV12 | - | 75/25 | 1 |
| COMP10 | - | 80/20 | 3 |
| COMP11 | - | 90/10 | 4 |
| COMP12 | 0/100 | - | 1 |
| COMP02 | 100/0 | - | 5 |
| COMP03 | | 100/0 | 4 |

From Table 9 it can be concluded that the coating comprising only a cyclic aliphatic crosslinking agent was very good for stickiness (COMP12). However, as can be seen from Example 5, coatings with only alicyclic crosslinking agents are not OK with respect to scratch resistance and therefore not suitable for a weather resistant outer layer.

When a mixture of aliphatic isocyanates and alicyclic isocyanates is used, the stickiness becomes acceptable when the molar ratio of the isocyanate groups of the aliphatic isocyanate crosslinking agents to the isocyanate groups of the alicyclic crosslinking agents is ≤ 3 (see Inventive examples and COMP08 to COMP11).

Exmple 4

In this example aliphatic (Desmodur N3300 and N3790) and cyclic aliphatic (Tolonate IDT70B) isocyanate crosslinking agents are evaluated.

The coatings were performed as in Example 1. The composition of the coatings are shown in Table 10.

To calculate the amount of the isocyanate compounds to arrive at a molar ratio [NCO]/[OH] of 1.1/1, it was taken into account that Desmodur N3300 contains 21.80 g NCO/100 g; Desmodur N3790 contains 17.80 g NCO/100 g; and Tolonate IDT70B contains 12.30 g NCO/100 g.

The ratios [NCO]_{DN3300}/[NCO]_{TIDT70B} and [NCO]_{DN3790}/[NCO] _{TIDT70B} referred to in Table 1 are the molar ratio of the NCO groups of respectively Desmodur N3300 and Desmodur N3790 to the NCO groups of Tolonate IDT70B.

**Table 10**

| Ingredients (g/m²) | INV13 | INV14 | INV15 | COMP13 | COMP14 | INV16 | |
|---|---|---|---|---|---|---|---|
| Zeffle GK-570 | 12.40 | = | = | = | = | = | |
| Ti0₂ | 9.50 | = | = | = | = | = | |
| Desmodur N3300 | 1.41 | 1.97 | 2.11 | 2.25 | 2.53 | - | |
| Desmodur N3790 | - | - | - | - | - | 1.72 | |
| Tolonate IDT70B | 2.50 | 1.50 | 1.25 | 1.00 | 0.50 | 2.50 | |
| [NCO] _{DN3300}/ [NCO] _{TIDT70B} | 50/50 | 70/30 | 75/25 | 80/20 | 90/10 | - | |
| [NCO] _{DN3790}/ [NCO] _{TIDT70B} | - | - | - | - | - | 50/50 | |
| Ingredients (g/m²) | INV17 | INV18 | COMP15 | COMP16 | COMP17 | COMP02 | COMP03 |
| Zeffle GK-570 | 12.40 | = | = | = | = | | |
| Ti0₂ | 9.50 | = | = | = | = | | |
| Desmodur N3300 | - | - | - | - | - | 2.82 | - |
| Desmodur N3790 | 2.41 | 2.59 | 2.76 | 3.10 | - | - | 3.45 |
| Tolonate IDT70B | 1.50 | 1.25 | 1.00 | 0.50 | 4.99 | - | - |
| [NCO] _{DN3790}/ [NCO] _{TIDT70B} | 70/30 | 75/25 | 80/20 | 90/10 | - | - | - |

Adhesion and stickiness tests were carried out as in Example 1. The adhesion, dry and wet, was OK for all samples. The overall stickiness results are shown in Table 11.

**Table 11**

| | [NCO] _{DN3300}/ [NCO] _{TIDT70B} | [NCO] _{DN3790}/ [NCO] _{TIDT70B} | Overall Stickiness |
|---|---|---|---|
| INV13 | 50/50 | - | 1 |
| INV14 | 70/30 | - | 1 |
| INV15 | 75/25 | - | 2 |
| COMP13 | 80/20 | - | 3 |
| COMP14 | 90/10 | - | 4 |
| INV16 | - | 50/50 | 1 |
| INV17 | - | 70/30 | 2 |
| INV18 | - | 75/25 | 2 |
| COMP15 | - | 80/20 | 3 |
| COMP16 | - | 90/10 | 5 |
| COMP17 | 0/100 | - | 1 |
| COMP02 | 100/0 | - | 5 |
| COMP03 | - | 100/0 | 4 |

From Table 11 it can be concluded that the coating comprising only a alicyclic crosslinking agent was very good for stickiness (COMP17). However, as can be seen from Example 5, coatings with only alicyclic crosslinking agents are not OK with respect to scratch resistance and therefore not suitable for a weather resistant outer layer.

When a mixture of aliphatic isocyanates and alicyclic isocyanates is used, the stickiness becomes acceptable when the molar ratio of the isocyanate groups of the aliphatic isocyanate crosslinking agents to the isocyanate groups of the alicyclic crosslinking agents is ≤ 3 (see Inventive examples and COMP13 to COMP16).

### Example 5

In this example the scratch resistance is evaluated.

The coatings were performed as in Example 1. The composition of the coatings are shown in Table 12.

**Table 12**

| Ingredients (g/m²) | COMP01 | INV01 | INV04 | COMP12 | INV07 | INV10 |
|---|---|---|---|---|---|---|
| Zeffle GK-570 | 12.40 | = | = | = | = | = |
| Ti0₂ | 9.50 | = | = | = | = | = |
| Desmodur N3300 | - | 1.41 | - | - | 1.41 | |
| Desmodur N3790 | - | - | 1.72 | - | - | 1.72 |
| Suprasec 2496 | 1.96 | 0.98 | 0.98 | - | - | |
| Vestanat T1890E | - | - | - | 5.12 | 2.56 | 2.56 |
| Tolonate IDT70B | - | - | - | - | - | |
| Ingredients (g/m²) | COMP17 | INV13 | INV16 | | | |
| Zeffle GK-570 | 12.40 | = | = | | | |
| Ti0₂ | 9.50 | = | = | | | |
| Desmodur N3300 | - | 1.41 | - | | | |
| Desmodur N3790 | - | - | 1.72 | | | |
| Tolonate IDT70B | 4.99 | 2.50 | 2.50 | | | |

The scratch resistance of the coating was evaluated.

The measurements were carried out on 35 x 100 mm samples of the coatings. The test was carried out at 50 % RH (+/- 3 %) and 21°C (+/- 1°C). The samples were conditioned in aluminum holders during minimum 4 hours before the start of the measurement.

The measurerments were based on ISO norm 4586-2:2004 (E).

The following parameters were used:
Speed: 30 mm/sec
Load: 10-500 mN
Length (test area): 100 mm
Diamond: 15µm radius 90°

The scratch resistance of the samples was determined with a diamond Indenter scratch test. A diamond needle is moved across the coating surface while the pressure onto the needle is being increased. The test starts with a pressure of 10 mN and the pressure goes up to 500 mN.

The result of the indenter scratch test is the pressure value, at which the first microscopic cracks in the pressure trail of the needle are observed. The position where the needle starts to penetrate into the coating is measured, and then correlated with the pressure at that point.

After the test the indenter will be cleaned ones more with Ethanol. The results of the scratch test are shown in Table 13. A higher number (higher pressure before cracks occur in the coating) means a better scratch resistance.

**Table 13**

| | Crosslinking agent | Scratch resistance (mN) |
|---|---|---|
| COMP01 | Suprasec 2496 | 249 |
| INV01 | [NCO] _{DN3300}/ [NCO] _{S2496} 50/50 | 210 |
| INV04 | [NCO]_{DN3790}/[NCO]_{S2496} 50/50 | 199 |
| COMP12 | Vestanat T1890E | 179 |
| INV07 | [NCO]_{DN3300}/ [NCO] _{VT1890E} (50/50) | 233 |
| INV10 | [NCO] _{DN3790}/ [NCO] _{VT1890E} (50/50) | 198 |
| COMP17 | Tolonate IDT70B | 162 |
| INV13 | [NCO] _{DN3300}/ [NCO]_{TIDT70B} (50/50) | 255 |
| INV16 | [NCO] _{DN3790}/ [NCO] _{TIDT70B} (50/50) | 252 |
| COMP02 | Desmodur N3300 | 260 |
| COMP03 | Desmodur N3790 | 253 |

It is clear from Table 13 that the scratch resistance of the coatings containing 100 % of an alicyclic isocyanate crosslinking agent (COMP12 and COMP17) was inferior compared to the coatings containing 100 % of an aromatic isocyanate crosslinking agent (COMP01), containing 100 % of an aliphatic isocyanate crosslinking agent (COMP02 and COMP03), or a mixture of an aliphatic isocyanate and an alicyclic isocyanate crosslinking agent(see Inventive Examples).

As illustrated in Examples 1 and 2, using 100 % aromatic isocyanate crosslinking agents however resulted in an unacceptible yellowing of the coating, while using 100 % aliphatic isocyanate crosslinking agents resulted in unacceptible stickiness of the coating.

## Claims

1. A solar cell module (5) comprising a solar cell element (3) encapsulated by an encapsulant (2, 2') and disposed between a front sheet (4) and a back sheet (1), **characterized in that** the back sheet (1) comprises a polymeric support (10), a weather resistant layer (13) on one side of the support and a primer (11) on the other side of the support facing the encapsulant (2') to enhance the adhesion of the back sheet towards the encapsulant layer (2'), the weather resistant layer comprising a binder containing a crosslinkable group and an aliphatic isocyanate crosslinking agent, **characterized in that** the weather resistant layer further comprises an aromatic or an alicyclic isocyanate crosslinking agent, wherein the molar ratio of the isocyanate groups of the aliphatic isocyanate crosslinking agents to the isocyanate groups of the aromatic and/or alicyclic crosslinking agents is ≤ 3, and wherein the crosslinkable group of the binder is a hydroxyl group.

2. The solar cell module according to claim 1 wherein the binder is a fluorine-based polymer.

3. The solar cell module according to claim 1 or 2 wherein the molar ratio of the total amount of isocyanate groups of the crosslinking agents to the total amount of hydroxyls groups of the binder ([NCO]/[OH]) is between 0.25 to 2.50.

4. The solar cell module according to any of the preceding claims wherein the weather resistant layer further comprises a tin, zinc or bismuth based catalyst, which improves the crosslinking efficiency.

5. The solar cell module according to claim 4 wherein the amount of the catalyst is between 0.005 and 3.00 wt % relative to the total weight of the binder having a crosslinkable group.

6. The solar cell module according to any of the preceding claims wherein the weather resistant layer further comprises Ti0₂ particles.

## Patentansprüche

1. Ein Solarzellenmodul (5), umfassend ein mittels eines Einkapselungsmittels (2, 2') eingekapseltes und zwischen einer vorderseitigen Folie (4) und einer rückseitigen Folie (1) angeordnetes Solarzellenelement (3), **dadurch gekennzeichnet, dass** die rückseitige Folie (1) einen polymeren Träger (10), eine witterungsbeständige Schicht (13) auf einer Seite des Trägers und einen Primer (11) auf der anderen, dem Einkapselungsmittel (2) zugewandten Seite des Trägers umfasst, um die Haftung der rückseitigen Folie an der Einkapselungsschicht (2') zu verbessern, wobei die witterungsbeständige Schicht ein eine vernetzbare Gruppe und ein aliphatisches Isocyanatvernetzungsmittel enthaltendes Bindemittel enthält, **dadurch gekennzeichnet, dass** die witterungsbeständige Schicht ferner ein aromatisches oder alicyclisches Isocyanatvernetzungsmittel enthält, wobei das Molverhältnis der Isocyanatgruppen der aliphatischen Isocyanatvernetzungsmittel zu den Isocyanatgruppen der aromatischen und/oder alicyclischen Vernetzungsmittel ≤ 3 liegt und die vernetzbare Gruppe des Bindemittels eine Hydroxylgruppe ist.

2. Das Solarzellenmodul nach Anspruch 1, wobei das Bindemittel ein Polymer auf Fluorbasis ist.

3. Das Solarzellenmodul nach Anspruch 1 oder 2, wobei das Molverhältnis der Gesamtmenge der Isocyanatgruppen der Vernetzungsmittel zur Gesamtmenge der Hydroxylgruppen des Bindemittels ([NCO]/[OH]) zwischen 0,25 und 2,50 liegt.

4. Das Solarzellenmodul nach einem der vorstehenden Ansprüche, wobei die witterungsbeständige Schicht ferner einen Katalysator auf Basis von Zinn, Zink oder Bismut, der die Vernetzungseffizienz verbessert, enthält.

5. Das Solarzellenmodul nach Anspruch 4, wobei die Menge Katalysator zwischen 0,005 und 3,00 Gew.-%, bezogen auf das Gesamtgewicht des eine vernetzbare Gruppe enthaltenden Bindemittels, liegt.

6. Das Solarzellenmodul nach einem der vorstehenden Ansprüche, wobei die witterungsbeständige Schicht ferner TiO₂-Partikel enthält.

## Revendications

1. Module de cellule solaire (5), comprenant un élément de cellule solaire (3) encapsulé au moyen d'un ensapculant (2, 2') et disposé entre une feuille avant (4) et une feuille arrière (1), **caractérisé en ce que** la feuille arrière (1) comprend un support polymère (10), une couche résistante aux intempéries (13) sur un côté du support et une couche de fond (11) sur l'autre côté du support dirigé vers l'encapsulant (2) afin d'améliorer l'adhésion de la feuille arrière à la couche encapsulante (2'), ladite couche résistante aux intempéries comprenant un liant contenant un groupe réticulable et un réticulant d'isocyanate aliphatique, **caractérisé en ce que** la couche résistante aux intempéries contient en outre un réticulant d'isocyanate aromatique ou alicyclique, le rapport molaire des groupes isocyanate des réticulants d'isocyanate aliphatiques aux groupes isocyanate des réticulants aromatiques et/ou alicycliques étant ≤ 3 et ledit groupe réticulable du liant étant un groupe hydroxyle.

2. Module de cellule solaire selon la revendication 1, **caractérisé en ce que** le liant est un polymère à base de fluor.

3. Module de cellule solaire selon la revendication 1 ou 2, **caractérisé en ce que** le rapport molaire de la quantité totale de groupes isocyanate des réticulants à la quantité totale de groupes hydroxyle du liant ([NCO]/[OH]) est compris entre 0,25 et 2,50.

4. Module de cellule solaire selon l'une quelconque des revendications précédentes, **caractérisé en ce que** la couche résistante aux intempéries contient en outre un catalyseur à base d'étain, de zinc ou de bismut afin d'améliorer l'efficacité de la réticulation.

5. Module de cellule solaire selon la revendication 4, **caractérisé en ce que** la quantité du catalyseur est comprise entre 0,005 et 3,00% en poids par rapport au poids total du liant comprenant un groupe réticulable.

6. Module de cellule solaire selon l'une quelconque des revendications précédentes, **caractérisé en ce que** la couche résistante aux intempéries contient en outre des particules de TiO₂.
